# EUROPEAN PATENT APPLICATION

(11) **EP 4 730 954 A1**
(43) Date of publication of application: **22.04.2026**
(21) Application number: 25193110.1
(22) Date of filing: 31.07.2025
(51) Int. Cl.: H10D 30/67, H10D 62/10, H10D 86/40

(54) **THIN FILM TRANSISTOR, THIN FILM TRANSISTOR SUBSTRATE COMPRISING THE SAME, AND DISPLAY APPARATUS COMPRISING THE SAME**

(30) Priority: 18.10.2024 KR 20240142981
(71) Applicant: LG Display Co., Ltd., Seoul, 07336 (KR)
(72) Inventor: JUNG, Jinwon, 10845 Paju-si, Gyeonggi-do (KR); JANG, Jaeman, 10845 Paju-si, Gyeonggi-do (KR)
(74) Representative: Viering, Jentschura & Partner mbB Patent- und Rechtsanwälte

(57) **Abstract**

An embodiment of the present invention provides a thin film transistor (100, 200, 300, 400, 500) including a source conductive layer (135) and a drain conductive layer (136) spaced apart from each other; an active layer (130) disposed between the source conductive layer (135) and the drain conductive layer (136); and a gate electrode (150) overlapping the active layer (130), wherein a direction from the drain conductive layer (136) to the source conductive layer (135) is referred to as a first direction (X) and a direction perpendicular to the first direction (X) is referred to as a second direction (Y), the active layer (130) is disposed to stand in a direction that is not parallel to the first direction (X) and the second direction (Y), and a maximum length of the active layer (130) in the second direction (Y) is longer than a minimum length of the active layer (130) in the first direction (X).

## Description

### BACKGROUND

### Field of the Invention

The present invention relates to a thin film transistor, a method for manufacturing the same, a thin film transistor substrate including the same, and a display apparatus including the same.

### Discussion of the Related Art

Since thin film transistors can be manufactured on glass or plastic substrates, they are widely used as switching elements or driving elements in display devices such as liquid crystal display devices or organic light emitting devices.

Thin film transistors can be classified into amorphous silicon thin film transistors in which amorphous silicon is used as the active layer, polycrystalline silicon thin film transistors in which polycrystalline silicon is used as an active layer, and oxide semiconductor thin film transistors in which oxide semiconductor is used as the active layer, based on the material constituting the active layer.

Recently, as the pixel density of high-resolution or mobile displays increases, many pixels are disposed in a narrow space, and the area of thin film transistors is getting smaller. In the past, when the area of thin film transistors was reduced, the cost of the process increased due to the limitations of the patterning process and the etching process, and it could be vulnerable to large-area integration. Recently, research is continuously being conducted to reduce the area of thin film transistors while solving these problems.

### SUMMARY

One object of the present invention is to provide a thin film transistor having a short channel including an active layer erected at a certain angle.

Another object of the present invention is to provide a thin film transistor having improved reliability and mobility, including a source conductive layer and a drain conductive layer having different work functions.

Another object of the present invention is to provide a thin film transistor having improved high junction stress (HJS) by disposing a plurality of active layers having different mobilities in the horizontal direction of a substrate.

Another object of the present invention is to provide a thin film transistor with a reduced area.

Another object of the present invention is to provide a thin film transistor substrate including such a thin film transistor.

Another object of the present invention is to provide a display apparatus including such a thin film transistor.

According to an aspect of the present invention, there is provided a thin film transistor according to claim 1. Preferred embodiments are described in the dependent claims. According to an aspect of the present invention for achieving the-described technical problem, there is provided a thin film transistor including a source conductive layer and a drain conductive layer spaced apart from each other; an active layer disposed between the source conductive layer and the drain conductive layer; and a gate electrode overlapping the active layer, wherein a direction from the drain conductive layer to the source conductive layer is referred to as a first direction and a direction perpendicular to the first direction is referred to as a second direction, the active layer is disposed to stand in a direction that is not parallel to the first direction and the second direction, and a maximum length of the active layer in the second direction is longer than a minimum length of the active layer in the first direction.

The active layer may have a first side surface in contact with the source conductive layer and a second side surface in contact with the drain conductive layer, and the first side surface and the second side surface may not be parallel to the first direction and the second direction, but can be parallel to each other.

An entire area of the active layer can overlap with the gate electrode.

An upper surface of the active layer, an upper surface of the source conductive layer, and an upper surface of the drain conductive layer can form one plane.

The thin film transistor may further include a buffer layer, wherein the active layer may be disposed on the buffer layer, and a lower surface of the active layer, a lower surface of the source conductive layer, and a lower surface of the drain conductive layer can be in contact with the buffer layer to form one plane.

The source conductive layer and the drain conductive layer may be made of different materials, and a work function of the source conductive layer may be smaller than a work function of the gate electrode, and a work function of the drain conductive layer may be larger than the work function of the gate electrode.

The active layer may include a first active layer in contact with the source conductive layer; and a second active layer in contact with the drain conductive layer, wherein the second active layer may not contact the source conductive layer, and in a part of the thickness of the active layer, an arbitrary straight line parallel to an upper surface of the active layer can pass through both the first active layer and the second active layer.

A mobility of the second active layer may be greater than a mobility of the first active layer.

The thin film transistor may further include a gate insulating film between the active layer and the gate electrode, and an upper surface of the first active layer and an upper surface of the second active layer can be in contact with the gate insulating film.

The active layer may further include a third active layer between the first active layer and the second active layer, the third active layer not in contact with the source conductive layer, and in a part of the thickness of the active layer, any straight line parallel to an upper surface of the active layer can pass through all of the first active layer, the second active layer, and the third active layer.

A mobility of the third active layer may be greater than the mobility of the first active layer and less than the mobility of the second active layer.

The thin film transistor may further include a gate insulating film between the active layer and the gate electrode, and an upper surface of the first active layer, an upper surface of the second active layer, and an upper surface of the third active layer can be in contact with the gate insulating film.

A groove may be formed (or provided) on the upper surface of the active layer, and the thickness of the active layer may be smaller than the thickness of the source conductive layer and the thickness of the drain conductive layer.

A protrusion may be formed (or provided) on the upper surface of the active layer, and the thickness of the active layer may be greater than the thickness of the source conductive layer and the thickness of the drain conductive layer.

The upper surface of the active layer may have a first length, the lower surface of the active layer may have a second length, the first length may be shorter than the second length, and the first length and the second length can be measured along a direction parallel to the first direction.

At least a portion of the source conductive layer and at least a portion of the drain conductive layer may overlap the gate electrode in a plane.

According to another aspect of the present invention, there is provided a thin film transistor substrate comprising: a base substrate; and a first thin film transistor and a second thin film transistor disposed on the base substrate, the first thin film transistor comprising: a first source conductive layer and a first drain conductive layer spaced apart from each other; a first sub-active layer disposed between the first source conductive layer and the first drain conductive layer; and a first gate electrode overlapping the first sub-active layer; and the second thin film transistor comprising: a second source conductive layer and a second drain conductive layer spaced apart from each other; a second sub-active layer disposed between the second source conductive layer and the second drain conductive layer; and a second gate electrode overlapping with the second sub-active layer, wherein a direction from the first drain conductive layer to the first source conductive layer is referred to as a first direction, and a direction perpendicular to the first direction is referred to as a second direction, the first sub-active layer and the second sub-active layer are disposed to be erected in a direction that is not parallel to the first direction and the second direction, and a maximum length of the first sub-active layer in the second direction is longer than a minimum length of the first sub-active layer in the first direction, and a maximum length of the second sub-active layer in the second direction is longer than a minimum length of the second sub-active layer in the first direction.

The first source conductive layer and the second source conductive layer may be formed integrally, and the first thin film transistor and the second thin film transistor can be connected in parallel.

The first sub-active layer may have a third side surface in contact with the first source conductive layer, the second sub-active layer may have a fourth side surface in contact with the second source conductive layer, and the third side surface and the fourth side surface may not be parallel to the first direction and the second direction, respectively.

An upper surface of the first drain conductive layer, an upper surface of the first sub-active layer, an upper surface of the first source conductive layer, an upper surface of the second source conductive layer, an upper surface of the second sub-active layer, and an upper surface of the second drain conductive layer can form one plane.

According to another aspect of the present invention, there is provided a method for manufacturing a thin film transistor comprising the steps of: forming a buffer layer on a base substrate; forming a first metal material layer on the buffer layer; forming an active material layer on the first metal material layer; forming a second metal material layer on the active material layer; performing a chemical mechanical polishing process to flatten upper surfaces of the first metal material layer, the active material layer, and the second metal material layer to form a source conductive layer and a drain conductive layer spaced apart from each other and an active layer disposed between the source conductive layer and the drain conductive layer; forming a gate insulating film on the source conductive layer, the drain conductive layer, and the active layer; and forming a gate electrode on the gate insulating film, wherein a direction from the drain conductive layer to the source conductive layer is referred to as a first direction and a direction perpendicular to the first direction is referred to as a second direction, the active layer is formed to be erected in a direction that is not parallel to the first direction and the second direction, and the maximum length of the active layer in the second direction is longer than the minimum length of the active layer in the first direction.

The first metal material layer and the second metal material layer may be made of different materials, and a work function of the second metal material layer may be greater than a work function of the first metal material layer.

According to another aspect of the present invention, there is provided a display apparatus including a thin film transistor as described above.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view of a thin film transistor according to one embodiment of the present invention.
FIG. 2 is a cross-sectional view of a thin film transistor according to one embodiment of the present invention.
FIG. 3 is a cross-sectional view of a thin film transistor according to another embodiment of the present invention.
FIG. 4 is a cross-sectional view of a thin film transistor according to another embodiment of the present invention.
FIG. 5 is a cross-sectional view of a thin film transistor according to another embodiment of the present invention.
FIG. 6 is a cross-sectional view of a thin film transistor according to another embodiment of the present invention.
FIG. 7 is a cross-sectional view of a thin film transistor substrate according to another embodiment of the present invention.
FIG. 8 is a circuit diagram of the thin film transistor substrate illustrated in FIG. 7.
FIGS. 9A to 9H are process diagrams showing a manufacturing process of a thin film transistor substrate according to another embodiment of the present invention.
FIG. 10 is a schematic diagram of a display apparatus according to another embodiment of the present invention.

### DETAILED DESCRIPTION OF THE DISCLOSURE

Advantages and features of the present disclosure and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete and will fully convey the scope of the present disclosure to those skilled in the art. Further, the present disclosure is only defined by scopes of claims.

A shape, a size, a ratio, an angle and a number disclosed in the drawings for describing embodiments of the present disclosure are merely an example and thus, the present disclosure is not limited to the illustrated details. Like reference numerals refer to like elements throughout the present disclosure. In the following description, when the detailed description of the relevant known function or configuration is determined to unnecessarily obscure the important point of the present disclosure, the detailed description will be omitted.

In a case where 'comprise', 'have' and 'include' described in the present disclosure are used, another portion may be added unless 'only~' is used. The terms of a singular form may include plural forms unless referred to the contrary.

In construing an element, the element is construed as including an error band although there is no explicit description.

In describing a position relationship, for example, when the position relationship is described as 'upon~', 'above~', 'below~' or 'next to~', one or more portions may be disposed between two other portions unless 'just' or 'direct' is used.

Spatially relative terms such as "below", "beneath", "lower", "above", and "upper" may be used herein to easily describe a relationship of one element or one group of elements to another element or another group of elements as illustrated in the drawings. It will be understood that these terms are intended to encompass different orientations of a device in addition to the orientation depicted in the drawings. For example, if the device illustrated in the figure is reversed, the device described to be arranged "below", or "beneath" another device may be arranged "above" another device. Therefore, an exemplary term "below or beneath" may include "below or beneath" and "above" orientations. Likewise, an exemplary term "above" or "on" may include "above" and "below or beneath" orientations.

In describing a temporal relationship, for example, when the temporal order is described as "after", "subsequent", "next", or "before," a case which is not continuous may be included, unless "just" or "direct" is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in a co-dependent relationship.

In the addition of reference numerals to the components of each drawing describing embodiments of the present disclosure, the same components can have the same sign as can be displayed on other drawings.

In the embodiments of the present disclosure, a source electrode and a drain electrode are distinguished for convenience of description, and the source electrode and the drain electrode may be interchanged. The source electrode may be the drain electrode and vice versa. In addition, the source electrode of any one embodiment may be a drain electrode in another embodiment, and the drain electrode of any one embodiment may be a source electrode in another embodiment.

In some embodiments of the present disclosure, for convenience of description, a source area is distinguished from a source electrode, and a drain area is distinguished from a drain electrode, but embodiments of the present disclosure are not limited thereto. The source area may be the source electrode, and the drain area may be the drain electrode. In addition, the source area may be the drain electrode, and the drain area may be the source electrode.

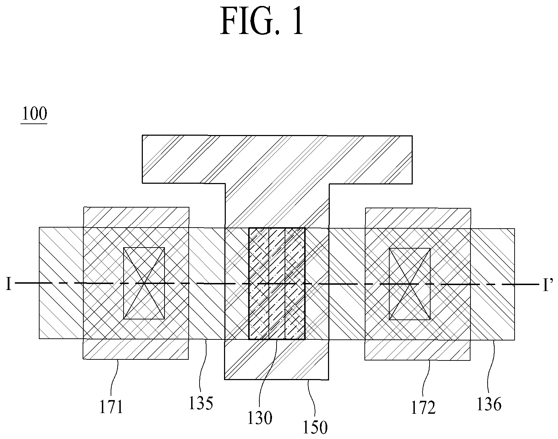

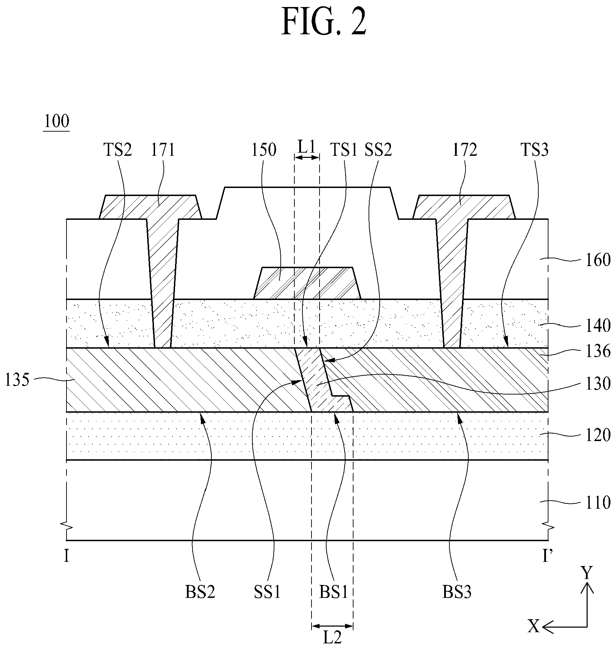

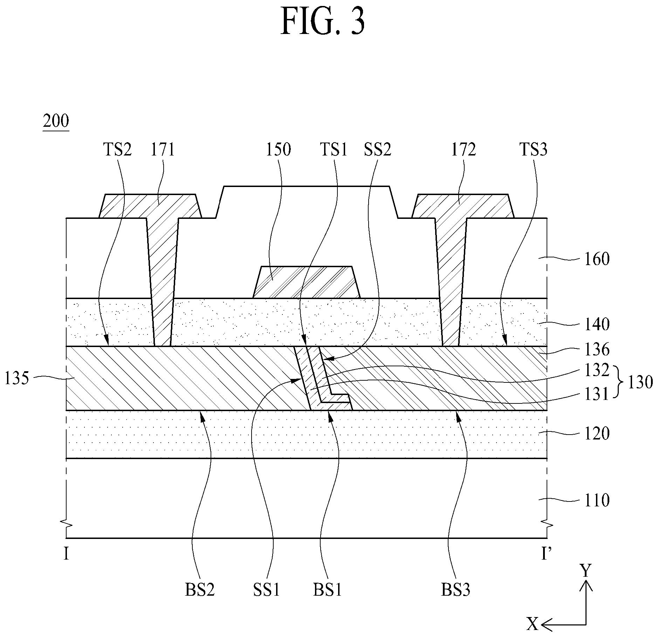

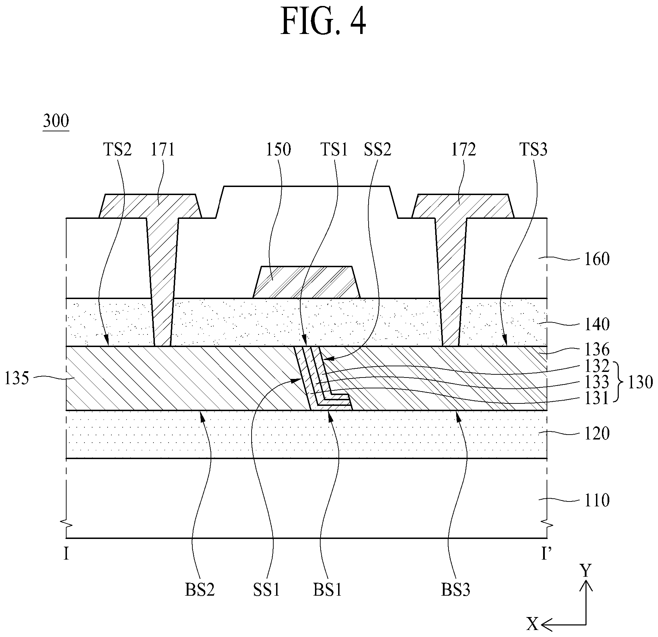

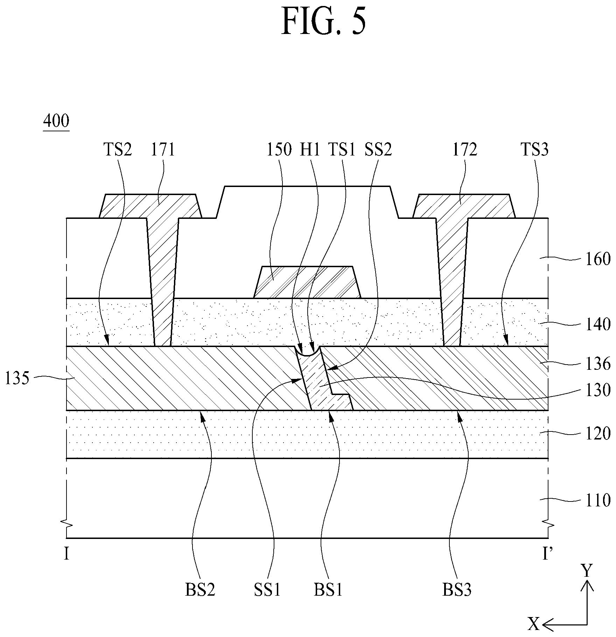

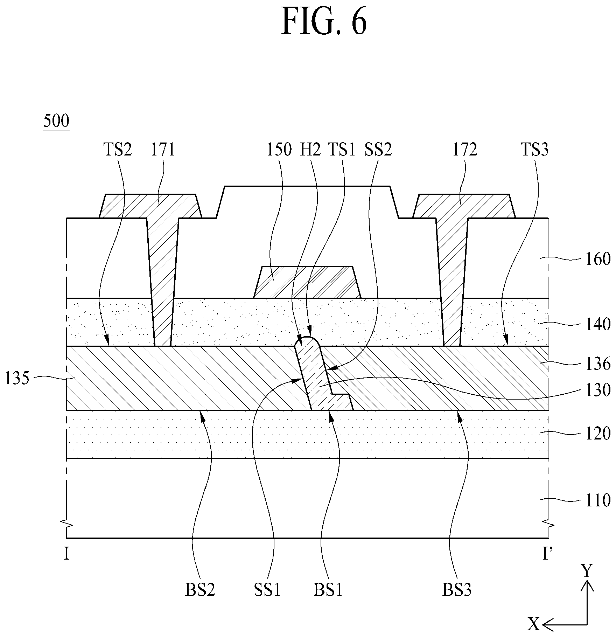

FIG. 1 is a plan view of a thin film transistor (100) according to an embodiment of the present invention. FIG. 2 is a cross-sectional view of a thin film transistor (100) according to an embodiment of the present invention. FIG. 3 is a cross-sectional view of a thin film transistor (200) according to an embodiment of the present invention. FIG. 4 is a cross-sectional view of a thin film transistor (300) according to an embodiment of the present invention. FIG. 5 is a cross-sectional view of a thin film transistor (400) according to an embodiment of the present invention. FIG. 6 is a cross-sectional view of a thin film transistor (500) according to an embodiment of the present invention. FIGS. 2 to 6 may correspond to cross-sectional views taken along line I-I' of FIG. 1.

A thin film transistor (100) according to one embodiment of the present invention includes a source conductive layer (135), a drain conductive layer (136) that are spaced apart from each other, an active layer (130), and a gate electrode (150).

According to one embodiment of the present invention, the source conductive layer (135), the drain conductive layer (136), the active layer (130), and the gate electrode (150) of the thin film transistor (100) may be disposed on a base substrate (110).

The components of the thin film transistor (100) are described in detail below.

Glass or plastic may be used as the material for forming the base substrate (110). A transparent plastic having flexible properties, such as polyimide, may be used as the plastic.

A light-blocking layer (not shown) may be disposed on the base substrate (110). The light-blocking layer (not shown) blocks light incident from the base substrate (110) and protects the active layer (130). If another structure serves as a light blocking structure, the light-blocking layer (not shown) may be omitted.

According to one embodiment of the present invention, a buffer layer (120) may be disposed on the base substrate (110).

The buffer layer (120) has insulating properties and protects the active layer (130). The buffer layer (120) may include at least one of insulating silicon oxide (SiOx), silicon nitride (SiNx), and metal oxide.

In FIG. 2, the buffer layer (120) is illustrated as a single layer, but one embodiment of the present invention is not limited thereto and may be a plurality of layers. In addition, another layer may be disposed between the base substrate (110) and the buffer layer (120), and another layer may be disposed between the buffer layer (120) and the active layer (130).

According to one embodiment of the present invention, the active layer (130) is disposed on the buffer layer (120).

According to one embodiment of the present invention, the active layer (130) may be made of any one of an oxide semiconductor material, low temperature polycrystalline silicon (LTPS), and amorphous silicon (A-Si).

According to one embodiment of the present invention, a source conductive layer (135) and a drain conductive layer (136) spaced apart from each other may be disposed on the buffer layer (120).

FIG. 2 illustrates a configuration in which a source conductive layer (135) and a drain conductive layer (136) are spaced apart from each other with an active layer (130) interposed therebetween.

According to one embodiment of the present invention, a direction from the drain conductive layer (136) to the source conductive layer (135) may be referred to as a first direction (X), and a direction perpendicular to the first direction (X) may be referred to as a second direction (Y).

For example, the first direction (X) may correspond to the horizontal direction of the base substrate (110), and the second direction (Y) may correspond to a direction parallel to a straight line connecting the base substrate (110) and the gate electrode (150) at the shortest distance.

According to one embodiment of the present invention, the active layer (130) may be disposed to stand in a direction that is not parallel to the first direction (X) and the second direction (Y). Specifically, the active layer (130) may be disposed to stand in a direction that is not parallel to the first direction (X) and not parallel to the second direction (Y).

For example, the maximum length of the active layer (130) in the second direction (Y) may be longer than the minimum length of the active layer (130) in the first direction (X). For example, the height of the active layer (130) may be greater than the length of the active layer (130). In this case, the height of the active layer (130) is measured in the second direction (Y), and the length of the active layer (130) is measured in the first direction (X).

According to one embodiment of the present invention, the active layer (130) is disposed at a certain angle so as to have a short channel. As a result, the area of the thin film transistor can be reduced, and the process cost of the thin film transistor can be reduced.

According to one embodiment of the present invention, the active layer (130) may have a first side surface (SS1) in contact with the source conductive layer (135) and a second side surface (SS2) in contact with the drain conductive layer (136).

For example, FIG. 2 illustrates a first side surface (SS1) and a second side surface (SS2) that are parallel. The first side surface (SS1) refers to a surface that is not parallel to the first direction (X) while contacting the source conductive layer (135) in the active layer (130). In addition, the second side surface (SS2) refers to a surface that is not parallel to the first direction (X) while contacting the drain conductive layer (136) in the active layer (130). For example, the first side surface (SS1) and the second side surface (SS2) may not be parallel to the first direction (X) and the second direction (Y).

According to one embodiment of the present invention, the active layer (130) may overlap with the gate electrode (150). According to one embodiment of the present invention, at least a portion of the source conductive layer (135) and at least a portion of the drain conductive layer (136) may overlap with the gate electrode (150) in a plan view. Additionally, another portion of the source conductive layer (135) and another portion of the drain conductive layer (136) may not overlap with the gate electrode (150).

For example, FIGS. 1 and 2 illustrate a view in which the entire area of the active layer (130) overlaps with the gate electrode (150). FIG. 1 illustrates a view in which the entire area of the active layer (130) overlaps with the gate electrode (150) in a plan view.

According to one embodiment of the present invention, the active layer (130) may have a step.

Referring to FIG. 2, the step of the active layer (130) may be a region formed by patterning the active layer (130). The step of the active layer (130) may overlap with the gate electrode (150).

According to one embodiment of the present invention, the active layer (130) may have a top surface (TS1), a first side surface (SS1), a second side surface (SS2), and a bottom surface (BS1).

According to one embodiment of the present invention, the source conductive layer (135) may have an upper surface (TS2) and a lower surface (BS2).

According to one embodiment of the present invention, the drain conductive layer (136) may have an upper surface (TS3) and a lower surface (BS3).

Referring to FIG. 2, the upper surface (TS1) of the active layer (130), the upper surface (TS2) of the source conductive layer (135), and the upper surface (TS3) of the drain conductive layer (136) can form one plane.

For example, a plane formed by the upper surface (TS1) of the active layer (130), the upper surface (TS2) of the source conductive layer (135), and the upper surface (TS3) of the drain conductive layer (136) may be parallel to the first direction (X) and may be parallel to the upper surface of the base substrate (110). For example, the upper surface (TS1) of the active layer (130), the upper surface (TS2) of the source conductive layer (135), and the upper surface (TS3) of the drain conductive layer (136) may be in contact with the gate insulating film (140) to form one plane.

Referring to FIG. 2, the lower surface (BS1) of the active layer (130), the lower surface (BS2) of the source conductive layer (135), and the lower surface (BS3) of the drain conductive layer (136) can form one plane.

For example, a plane formed by the lower surface (BS1) of the active layer (130), the lower surface (BS2) of the source conductive layer (135), and the lower surface (BS3) of the drain conductive layer (136) may be parallel to the first direction (X) and may be parallel to the upper surface of the base substrate (110). For example, the lower surface (BS1) of the active layer (130), the lower surface (BS2) of the source conductive layer (135), and the lower surface (BS3) of the drain conductive layer (136) may be in contact with the buffer layer (120) to form one plane.

Specifically, a plane formed by the upper surface (TS1) of the active layer (130), the upper surface (TS2) of the source conductive layer (135), and the upper surface (TS3) of the drain conductive layer (136) may be parallel to a plane formed by the lower surface (BS1) of the active layer (130), the lower surface (BS2) of the source conductive layer (135), and the lower surface (BS3) of the drain conductive layer (136).

However, one embodiment of the present invention is not limited thereto, and the active layer (130) may be over-etched or under-etched due to an etching difference caused by a difference in materials of the active layer (130), the source conductive layer (135), and the drain conductive layer (136) (see FIGS. 5 and 6).

According to one embodiment of the present invention, the source conductive layer (135) and the drain conductive layer (136) may each include at least one of gold (Au), nickel (Ni), copper (Cu), platinum (Pt), aluminum (Al), titanium (Ti), and chromium (Cr). However, one embodiment of the present invention is not limited thereto.

Specifically, the source conductive layer (135) and the drain conductive layer (136) may be made of different materials. For example, the work function of the source conductive layer (135) may be smaller than the work function of the gate electrode (150), and the work function of the drain conductive layer (136) may be larger than the work function of the gate electrode (150).

For example, when the work function of the gate electrode (150) is 4.7 eV, the work function of the source conductive layer (135) may be less than 4.7 eV, and the work function of the drain conductive layer (136) may be greater than 4.7 eV. In other words, the work function of the source conductive layer (135) and the work function of the drain conductive layer (136) may vary depending on the work function of the gate electrode (150). According to one embodiment of the present invention, the ranges of the work function values of the source conductive layer (135) and the drain conductive layer (136) do not overlap.

For example, when the gate electrode (150) is made of copper (Cu), the source conductive layer (135) may include at least one of aluminum (Al), titanium (Ti), nickel (Ni), and chromium (Cr), and the drain conductive layer (136) may include at least one of gold (Au) and platinum (Pt).

When the work function of the source conductive layer (135) is smaller than the work function of the gate electrode (150), carrier injection into the active layer (130) becomes easier, so that the current characteristics of the thin film transistor can be improved.

In addition, when the work function of the drain conductive layer (136) is greater than the work function of the gate electrode (150), carrier mobility from the active layer (130) to the drain conductive layer (136) is improved, so that the current characteristics in the on state of the thin film transistor can be improved, and the reliability of the thin film transistor can be improved.

In general, for thin film transistors, conductorization may be required for electrical contact between the active layer and other components. However, process errors may occur during the conductorization process for the active layer.

According to the present invention, by directly contacting the active layer (130), the source conductive layer (135), and the drain conductive layer (136), a conductorization process may not be required, and as a result, a process error due to the conductorization process may be prevented from occurring.

According to one embodiment of the present invention, a gate insulating film (140) is disposed on an active layer (130). Specifically, the gate insulating film (140) is disposed between the active layer (130) and a gate electrode (150).

According to one embodiment of the present invention, the gate insulating film (140) can cover the entire upper surface of the active layer (130). FIG. 2 illustrates a gate insulating film (140) covering the entire upper surfaces of a plurality of active layers (130).

The gate insulating film (140) may include at least one of silicon oxide, silicon nitride, and metal oxide. The gate insulating film (140) may have a single film structure or a multilayer film structure. The gate insulating film (140) protects the active layer (130).

According to one embodiment of the present invention, a gate electrode (150) may be disposed on the gate insulating film (140).

According to one embodiment of the present invention, the gate electrode (150) may overlap the active layer (130). For example, referring to FIG. 2, the gate electrode (150) may overlap the entire area of the active layer (130).

The gate electrode (150) may include at least one of an aluminum series metal such as aluminum (Al) or an aluminum alloy, a silver series metal such as silver (Ag) or a silver alloy, a copper series metal such as copper (Cu) or a copper alloy, a molybdenum series metal such as molybdenum (Mo) or a molybdenum alloy, chromium (Cr), tantalum (Ta), neodymium (Nd), and titanium (Ti). The gate electrode (150) may also have a multilayer film structure including at least two conductive films having different physical properties.

An interlayer insulating film (160) is disposed on the gate electrode (150). The interlayer insulating film (160) is an insulating layer made of an insulating material. Specifically, the interlayer insulating film (160) may be made of an organic material, an inorganic material, or a laminate of an organic layer and an inorganic layer.

A source electrode (171) and a drain electrode (172) are disposed on the interlayer insulating film (160). The source electrode (171) and the drain electrode (172) are spaced apart from each other and connected to a source conductive layer (135) and a drain conductive layer (136), respectively. The source electrode (171) and the drain electrode (172) are connected to the source conductive layer (135) and the drain conductive layer (136), respectively, through contact holes formed in the interlayer insulating film (160).

The source electrode (171) and the drain electrode (172) may each include at least one of molybdenum (Mo), aluminum (Al), chromium (Cr), gold (Au), titanium (Ti), nickel (Ni), neodymium (Nd), copper (Cu), and alloys thereof. The source electrode (171) and the drain electrode (172) may each be formed of a single layer made of a metal or an alloy of metals, or may be formed of multilayers including two or more layers.

According to one embodiment of the present invention, the active layer (130) may be formed of multiple layers. For example, the active layer (130) may include a first active layer (131) and a second active layer (132), as shown in FIG. 3.

Referring to FIG. 3, the first active layer (131) may be in contact with the source conductive layer (135), and the second active layer (132) may be in contact with the drain conductive layer (136). For example, the second active layer (132) may not be in contact with the source conductive layer (135).

Referring to FIG. 3, in a part of the thickness of the active layer (130), any straight line parallel to the upper surface (TS1) of the active layer (130) can pass through both the first active layer (131) and the second active layer (132). For example, any straight line parallel to the upper surface of the base substrate (110) can pass through both the first active layer (131) and the second active layer (132).

When a gate voltage is applied to the gate electrode (150), current can flow through the path of the active layer (130) that is closer to the gate electrode (150). According to one embodiment of the present invention, the gate electrode (150) is disposed on the active layer (130). Therefore, when a gate voltage is applied to the gate electrode (150), current can flow through the upper region of the active layer (130), and can flow while passing through the upper regions of both the first active layer (131) and the second active layer (132).

According to one embodiment of the present invention, both the upper surface of the first active layer (131) and the upper surface of the second active layer (132) can be in contact with the gate insulating film (140). The upper surface (TS1) of the active layer (130) can be formed by the upper surface of the first active layer (131) and the upper surface of the second active layer (132).

According to one embodiment of the present invention, the mobility of the second active layer (132) may be greater than the mobility of the first active layer (131). For example, the mobility of the second active layer (132) in contact with the drain conductive layer (136) may be greater than the mobility of the first active layer (131) in contact with the source conductive layer (135).

In general, high junction stress (HJS) refers to stress that occurs when carriers move between two different media within a transistor, for example, between a source conductive layer (135) and an active layer (130) or between an active layer (130) and a drain conductive layer (136).

For example, when high junction stress (HJS) is applied to a thin film transistor, mobility degradation may occur over time, which may deteriorate the current characteristics of the thin film transistor.

When the mobility of the second active layer (132) is greater than the mobility of the first active layer (131), carrier movement in the second active layer (132) increases, so that high junction stress (HJS) in the thin film transistor can be relieved. As a result, the current characteristics of the thin film transistor can be improved.

For example, the mobility of the first active layer (131) may range from 1 cm²/Vs to 10 cm²/Vs, and the mobility of the second active layer (132) may exceed 10 cm²/Vs and be equal to or less than 100 cm²/Vs. However, the embodiment of the present invention is not limited thereto.

According to one embodiment of the present invention, the active layer (130) may further include a third active layer (133) between the first active layer (131) and the second active layer (132), as shown in FIG. 4.

Referring to FIG. 4, the second active layer (132) and the third active layer (133) may not be in contact with the source conductive layer (135). For example, the first active layer (131) may be disposed between the source conductive layer (135) and the third active layer (133), and the second active layer (132) may be disposed between the third active layer (133) and the drain conductive layer (136).

Referring to FIG. 4, in a part of the thickness of the active layer (130), any straight line parallel to the upper surface (TS1) of the active layer (130) can pass through all of the first active layer (131), the second active layer (132), and the third active layer (133). For example, in a part of the thickness of the active layer (130), any straight line parallel to the upper surface of the base substrate (110) can pass through all of the first active layer (131), the second active layer (132), and the third active layer (133).

When a gate voltage is applied to the gate electrode (150), current can flow through the path of the active layer (130) that is closer to the gate electrode (150). According to one embodiment of the present invention, the gate electrode (150) is disposed on the upper portion of the active layer (130). Therefore, when a gate voltage is applied to the gate electrode (150), current can flow through the upper region of the active layer (130), and can flow while passing through the upper regions of the first active layer (131), the second active layer (132), and the third active layer (133).

According to one embodiment of the present invention, the upper surface of the first active layer (131), the upper surface of the second active layer (132), and the upper surface of the third active layer (133) can all be in contact with the gate insulating film (140). The upper surface (TS1) of the active layer (130) can be formed by the upper surface of the first active layer (131), the upper surface of the second active layer (132), and the upper surface of the third active layer (133).

The mobility of the third active layer (133) may be greater than the mobility of the first active layer (131) and less than the mobility of the second active layer (132). For example, the mobility may be smaller in the order of, the second active layer (132), the third active layer (133), and the first active layer (131).

According to one embodiment of the present invention, a groove (H1) may be formed (or provided) on the upper surface (TS1) of the active layer (130), as shown in FIG. 5. When the source conductive layer (135), the active layer (130), and the drain conductive layer (136) are etched, the active layer (130) may be over-etched due to differences in material properties among the source conductive layer (135), the active layer (130), and the drain conductive layer (136). As a result, a groove (H1) may be formed (or provided) on the upper surface (TS1) of the active layer (130).

Referring to FIG. 5, the shortest distance between the upper surface of the buffer layer (120) and the upper surface (TS1) of the active layer (130) may be shorter than the shortest distance between the upper surface of the buffer layer (120) and the upper surface (TS2) of the source conductive layer (135) or the upper surface (TS3) of the drain conductive layer (136).

For example, when the groove (H1) is formed (or provided) in the active layer (130), the thickness of the active layer (130) may be smaller than the thicknesses of the source conductive layer (135) and the drain conductive layer (136). In this case, the thickness may be measured along the second direction (Y).

Referring to FIG. 5, a groove (H1) formed (or provided) on the upper surface (TS1) of the active layer (130) can be filled with a gate insulating film (140).

According to one embodiment of the present invention, a protrusion (H2) may be formed (or provided) on the upper surface (TS1) of the active layer (130), as shown in FIG. 6. When the source conductive layer (135), the active layer (130), and the drain conductive layer (136) are etched, the active layer (130) may be less etched due to differences in material properties among the source conductive layer (135), the active layer (130), and the drain conductive layer (136). Therefore, a protrusion (H2) may be formed (or provided) on the upper surface (TS1) of the active layer (130).

Referring to FIG. 6, the shortest distance between the upper surface of the buffer layer (120) and the upper surface (TS1) of the active layer (130) may be longer than the shortest distance between the upper surface of the buffer layer (120) and the upper surface (TS2) of the source conductive layer (135) or the upper surface (TS3) of the drain conductive layer (136).

For example, when the protrusion (H2) is formed (or provided) in the active layer (130), the thickness of the active layer (130) may be greater than the thicknesses of the source conductive layer (135) and the drain conductive layer (136). In this case, the thickness may be measured along the second direction (Y).

According to one embodiment of the present invention, the upper surface (TS1) of the active layer (130) may have a first length (L1), and the lower surface (BS1) of the active layer (130) may have a second length (L2), as shown in FIG. 2. Referring to FIG. 2, the second length (L2) may be longer than the first length (L1). In other words, the first length (L1) may be shorter than the second length (L2). For example, the first length (L1) may be in a range of 10 to 50 nm. Referring to FIG. 2, the first length (L1) of the upper surface (TS1) of the active layer (130) and the second length (L2) of the lower surface (BS1) of the active layer (130) may be narrower than the width of the gate electrode.

According to one embodiment of the present invention, the first length (L1) of the upper surface (TS1) and the second length (L2) of the lower surface (BS1) are each measured along a direction parallel to the first direction (X).

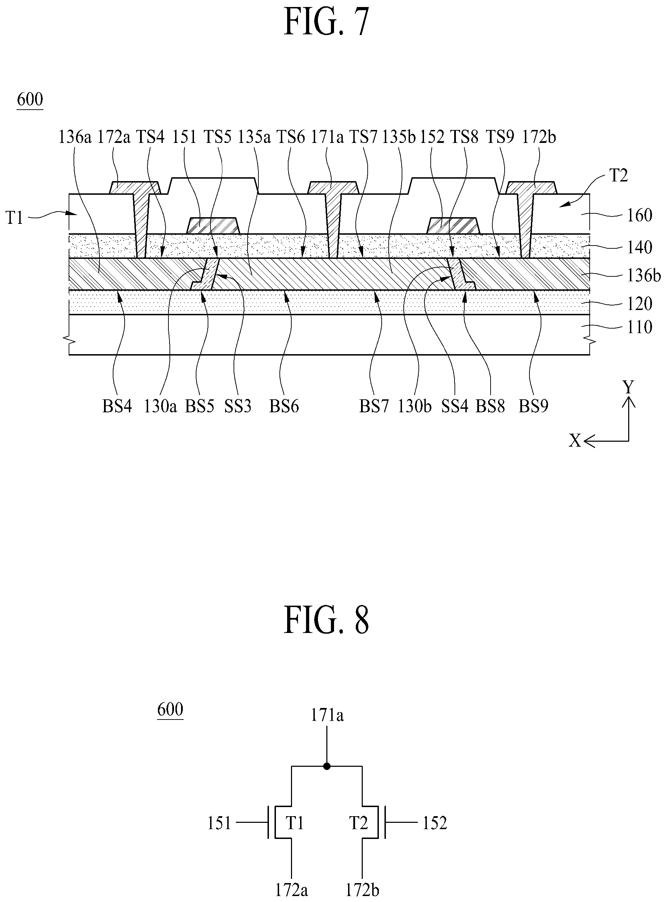

FIG. 7 is a cross-sectional view of a thin film transistor substrate (600) according to another embodiment of the present invention. FIG. 8 is a circuit diagram of the thin film transistor substrate (600) illustrated in FIG. 7.

The thin film transistor substrate (600) according to one embodiment of the present invention may include a base substrate (110), a first thin film transistor (T1) and a second thin film transistor (T2) disposed on the base substrate (110).

The first thin film transistor (T1) includes a first source conductive layer (135a), a first drain conductive layer (136a) spaced apart from each other, a first sub-active layer (130a) disposed between the first source conductive layer (135a) and the first drain conductive layer (136a), and a gate electrode (151).

The second thin film transistor (T2) includes a second source conductive layer (135b), a second drain conductive layer (136b) spaced apart from each other, a second sub-active layer (130b) disposed between the second source conductive layer (135b) and the second drain conductive layer (136b), and a gate electrode (152).

Descriptions of the first source conductive layer (135a) and the second source conductive layer (135b) are omitted as they overlap with the description of the source conductive layer (135) in FIG. 2.

Descriptions of the first drain conductive layer (136a) and the second drain conductive layer (136b) are omitted as they overlap with the description of the drain conductive layer (136) in FIG. 2.

Descriptions of the first sub-active layer (130a) and the second sub-active layer (130b) overlap with the description of the active layer (130) in FIG. 2 and are therefore omitted.

Descriptions of the first gate electrode (151) and the second gate electrode

(152) overlap with the description of the gate electrode (150) in FIG. 2 and are therefore omitted.

In addition, the description of the base substrate (110), the buffer layer (120), the gate insulating film (140), and the interlayer insulating film (160) illustrated in FIG. 7 is omitted as it overlaps with the description of related components in FIG. 2.

According to one embodiment of the present invention, the first sub-active layer (130a) and the second sub-active layer (130b) are disposed to stand in a direction that is not parallel to the first direction (X) and the second direction (Y).

According to one embodiment of the present invention, the maximum length of the first sub-active layer (130a) and the second sub-active layer (130b) in the second direction (Y) may be longer than the minimum length of the first sub-active layer (130a) and the second sub-active layer (130b) in the first direction (X).

According to one embodiment of the present invention, the first source conductive layer (135a) and the second source conductive layer (135b) may be formed integrally. For example, referring to FIGS. 7 and 8, the first thin film transistor (T1) and the second thin film transistor (T2) may be formed in parallel. For example, the first source conductive layer (135a) of the first thin film transistor (T1) and the second source conductive layer (135b) of the second thin film transistor (T2) are commonly connected to the source electrode (171a). For example, the first drain electrode (172a) of the first thin film transistor (T1) and the second drain electrode (172b) of the second thin film transistor (T2) are respectively connected to the first drain conductive layer (136a) and the second drain conductive layer (136b).

According to one embodiment of the present invention, the first source conductive layer (135a) may be disposed between the first drain conductive layer (136a) and the second source conductive layer (135b), and the second source conductive layer (135b) may be disposed between the second drain conductive layer (136b) and the first source conductive layer (135a).

According to one embodiment of the present invention, the first sub-active layer (130a) may have a third side surface (SS3) in contact with the first source conductive layer (135a), and the second sub-active layer (130b) may have a fourth side surface (SS4) in contact with the second source conductive layer (135b).

For example, referring to FIG. 7, the third side surface (SS3) and the fourth side surface (SS4) may not be parallel to each other and may have the same taper angle. For example, the third side (SS3) and the fourth side surface (SS4) may be disposed symmetrically with respect to the first source conductive layer (135a) and the second source conductive layer (135b) that are formed integrally. For example, the third side surface (SS3) and the fourth side surface (SS4) may not be parallel to the first direction (X) and the second direction (Y), respectively.

According to one embodiment of the present invention, an upper surface (TS4) of the first drain conductive layer (136a), an upper surface (TS5) of the first sub-active layer (130a), an upper surface (TS6) of the first source conductive layer (135a), an upper surface (TS7) of the second source conductive layer (135b), an upper surface (TS8) of the second sub-active layer (130b), and an upper surface (TS9) of the second drain conductive layer (136b) can form one plane.

According to one embodiment of the present invention, a lower surface (BS4) of the first drain conductive layer (136a), a lower surface (BS5) of the first sub-active layer (130a), a lower surface (BS6) of the first source conductive layer (135a), a lower surface (BS7) of the second source conductive layer (135b), a lower surface (BS8) of the second sub-active layer (130b), and a lower surface (BS9) of the second drain conductive layer (136b) can form one plane.

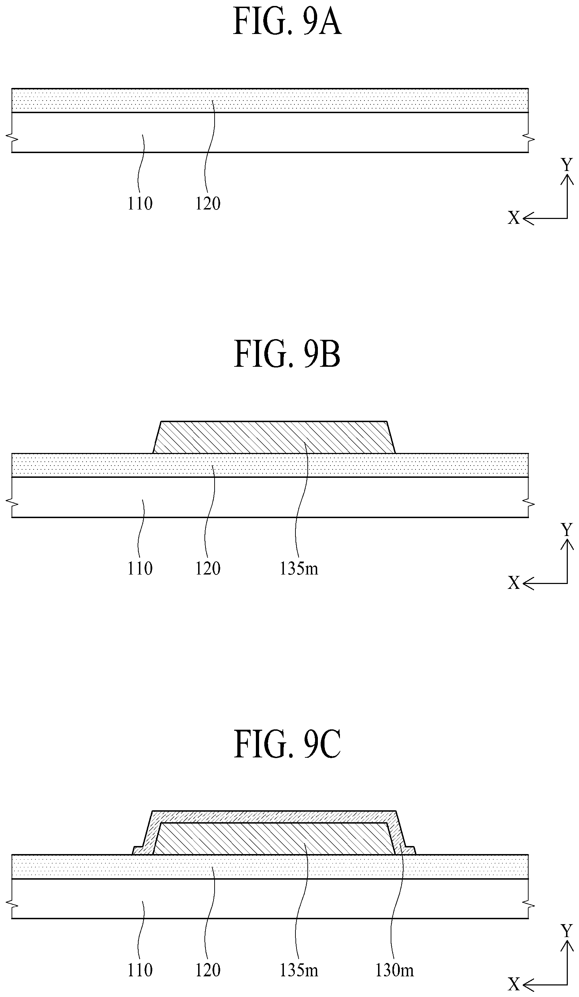

FIGs. 9A to 9H are manufacturing process diagrams of a thin film transistor (100) according to another embodiment of the present invention. The details of the configuration already described above are omitted.

Referring to FIG. 9A, a buffer layer (120) can be formed on a base substrate (110). The buffer layer (120) can be disposed over the entire base substrate (110).

Referring to FIG. 9B, a first metal material layer (135m) can be formed on the buffer layer (120). The first metal material layer (135m) is formed by being patterned on the buffer layer (120). The first metal material layer (135m) can include at least one of gold (Au), nickel (Ni), copper (Cu), platinum (Pt), aluminum (Al), titanium (Ti), and chromium (Cr). However, the embodiment of the present invention is not limited thereto.

Referring to FIG. 9C, an active material layer (130m) can be formed on the first metal material layer (135m). The active material layer (130m) can be made of any one of an oxide semiconductor material, low temperature polycrystalline silicon (LTPS), and amorphous silicon (A-Si).

The active material layer (130m) is formed by patterning on the first metal material layer (135 m).

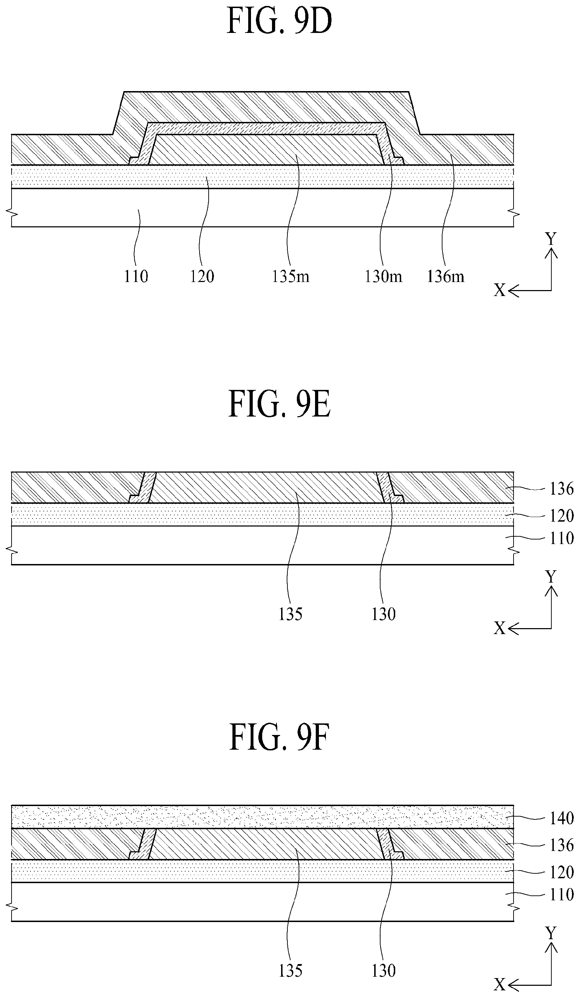

Referring to FIG. 9D, a second metal material layer (136m) may be formed on the active material layer (130m). The second metal material layer (136m) may include at least one of gold (Au), nickel (Ni), copper (Cu), platinum (Pt), aluminum (Al), titanium (Ti), and chromium (Cr). However, the embodiment of the present invention is not limited thereto.

According to one embodiment of the present invention, the first metal material layer (135m) and the second metal material layer (136m) may be formed of different materials. For example, the work function of the first metal material layer (135m) may be smaller than the work function of the gate electrode (150), and the work function of the second metal material layer (136m) may be larger than the work function of the gate electrode (150). For example, when the gate electrode (150) is formed of copper (Cu), the first metal material layer (135m) may include at least one of aluminum (Al), titanium (Ti), nickel (Ni), and chromium (Cr), and the second metal material layer (136m) may include at least one of gold (Au) and platinum (Pt).

Referring to FIG. 9E, a chemical mechanical polishing (CMP) process can be performed to flatten the upper surfaces of the first metal material layer (135m), the active material layer (130m), and the second metal material layer (136m). By the chemical mechanical polishing (CMP) process, a source conductive layer (135) and a drain conductive layer (136) spaced apart from each other and an active layer (130) disposed between the source conductive layer (135) and the drain conductive layer (136) can be formed.

For example, the active material layer (130m) and the second metal material (136m) may be partially etched to flatten the upper surfaces of the first metal material layer (135m), the active material layer (130m), and the second metal material layer (136m). The first metal material layer (135m) may also be partially etched.

Referring to FIG. 9F, a gate insulating film (140) can be formed on the source conductive layer (135), the drain conductive layer (136), and the active layer (130). The description of the gate insulating film (140) is omitted as it overlaps with the previous content.

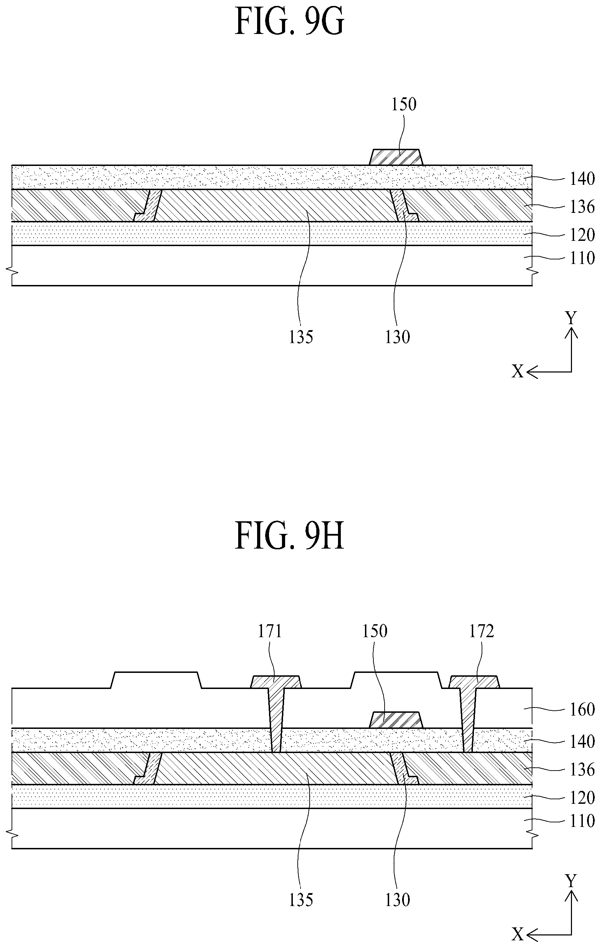

Referring to FIG. 9G, a gate electrode (150) can be formed on the gate insulating film (140). The description of the gate electrode (150) is omitted because it overlaps with the previous content. FIG. 9G illustrates a gate electrode (150) being disposed only on the right side of the drawing.

Referring to FIG. 9H, an interlayer insulating film (160), a source electrode (171), and a drain electrode (172) can be formed on the gate electrode (150). Descriptions of the interlayer insulating film (160), the source electrode (171), and the drain electrode (172) are omitted as they overlap with the previous contents.

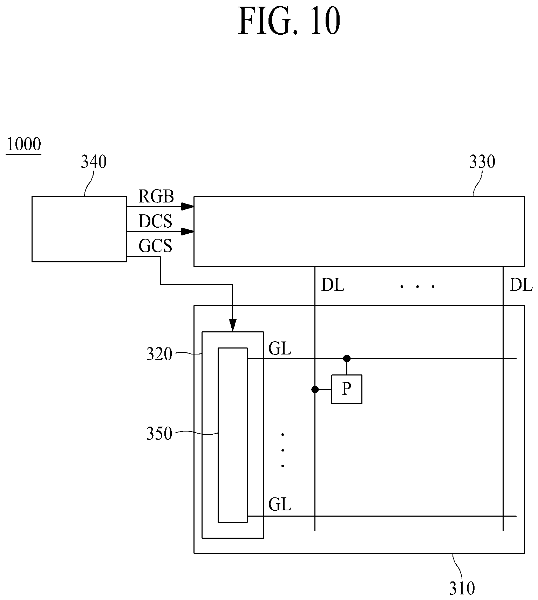

FIG. 10 is a schematic diagram illustrating a display apparatus (1000) according to further still another embodiment of the present disclosure.

As shown in FIG. 10, the display apparatus (1000) according to further still another embodiment of the present disclosure may include a display panel (310), a gate driver (320), a data driver (330) and a controller (340).

The display panel (310) includes gate lines (GL) and data lines (DL), and pixels (P) are disposed in intersection areas of the gate lines (GL) and the data lines (DL). An image is displayed by driving of the pixels (P). The gate lines (GL), the data lines (DL) and the pixels (P) may be disposed on the base substrate (110).

The controller (340) controls the gate driver (320) and the data driver (330).

The controller (340) outputs a gate control signal (GCS) for controlling the gate driver (320) and a data control signal (DCS) for controlling the data driver (330) by using a signal supplied from an external system not shown. Also, the controller (340) samples input image data input from the external system, realigns the sampled data and supplies the realigned digital image data (RGB) to the data driver (330).

The gate control signal (GCS) includes a gate start pulse (GSP), a gate shift clock (GSC), a gate output enable signal (GOE), a start signal (Vst) and a gate clock (GCLK). Also, control signals for controlling a shift register may be included in the gate control signal (GCS).

The data control signal (DCS) includes a source start pulse SSP, a source shift clock signal (SSC), a source output enable signal (SOE) and a polarity control signal (POL).

The data driver (330) supplies a data voltage to the data lines (DL) of the display panel (310). In detail, the data driver (330) converts the image data (RGB) input from the controller (340) into an analog data voltage and supplies the data voltage to the data lines (DL).

According to one embodiment of the present disclosure, the gate driver (320) may be packaged on the display panel (310). In this way, a structure in which the gate driver (320) is directly packaged on the display panel (310) will be referred to as a Gate In Panel (GIP) structure. In detail, in the Gate In Panel (GIP) structure, the gate driver (320) may be disposed on the base substrate (110).

The display apparatus (1000) according to one embodiment of the present disclosure may include the above-described thin film transistors substrate (100, 200, 300, 400 and 500). According to one embodiment of the present disclosure, the gate driver (320) may include the above-described thin film transistors substrate (100, 200, 300, 400 and 500).

The gate driver (320) may include a shift register (350).

The shift register (350) sequentially supplies gate pulses to the gate lines (GL) for one frame by using the start signal and the gate clock, which are transmitted from the controller (340). In this case, one frame means a time period at which one image is output through the display panel (310). The gate pulse has a turn-on voltage capable of turning on a switching device (thin film transistor) disposed in the pixel (P).

Also, the shift register (350) supplies a gate-off signal capable of turning off the switching device, to the gate line (GL) for the other period of one frame, at which the gate pulse is not supplied. Hereinafter, the gate pulse and the gate-off signal will be collectively referred to as a scan signal (SS or Scan).

The shift register (350) may include the thin film transistor substrate (100, 200, 300, 400, and 500) described above.

The following examples pertain to embodiments of the present invention:
Example 1: A thin film transistor comprising: a source conductive layer and a drain conductive layer spaced apart from each other; an active layer disposed between the source conductive layer and the drain conductive layer; and a gate electrode overlapping the active layer, wherein a direction from the drain conductive layer to the source conductive layer is referred to as a first direction and a direction perpendicular to the first direction is referred to as a second direction, wherein the active layer is disposed to stand in a direction that is not parallel to the first direction and the second direction, and wherein a maximum length of the active layer in the second direction is longer than a minimum length of the active layer in the first direction.
Example 2: The thin film transistor of Example 1, wherein the active layer has a first side surface in contact with the source conductive layer and a second side surface in contact with the drain conductive layer, and wherein the first side surface and the second side surface are not parallel to the first direction and the second direction, and are parallel to each other.
Example: 3: The thin film transistor of Example 1 or 2, wherein an entire area of the active layer overlaps with the gate electrode.
Example 4: The thin film transistor of any of Examples 1 to 3, wherein an upper surface of the active layer, an upper surface of the source conductive layer, and an upper surface of the drain conductive layer form one plane.
Example 5: The thin film transistor of any of Examples 1 to 4, further including a buffer layer, wherein the active layer is disposed on the buffer layer, and wherein a lower surface of the active layer, a lower surface of the source conductive layer, and a lower surface of the drain conductive layer are in contact with the buffer layer to form one plane.
Example: 6: The thin film transistor of any of Examples 1 to 5, wherein the source conductive layer and the drain conductive layer are made of different materials, wherein a work function of the source conductive layer is smaller than a work function of the gate electrode, and wherein a work function of the drain conductive layer is larger than the work function of the gate electrode.
Example 7: The thin film transistor of any of Examples 1 to 6, wherein the active layer includes: a first active layer in contact with the source conductive layer; and a second active layer in contact with the drain conductive layer, wherein the second active layer does not contact the source conductive layer, and wherein in a part of the thickness of the active layer, an arbitrary straight line parallel to an upper surface of the active layer passes through the first active layer and the second active layer.
Example 8: The thin film transistor of Example 7, wherein a mobility of the second active layer is greater than a mobility of the first active layer.
Example 9: The thin film transistor of Example 7 or 8, further including a gate insulating film between the active layer and the gate electrode, and wherein an upper surface of the first active layer and an upper surface of the second active layer are in contact with the gate insulating film.
Example 10: The thin film transistor of Example 7 or 8, wherein the active layer further includes a third active layer between the first active layer and the second active layer, wherein the third active layer is not in contact with the source conductive layer, and wherein in a part of the thickness of the active layer, any straight line parallel to an upper surface of the active layer passes through the first active layer, the second active layer, and the third active layer.
Example 11: The thin film transistor of Example 10, wherein a mobility of the third active layer is greater than the mobility of the first active layer and less than the mobility of the second active layer.
Example 12: The thin film transistor of Example 10 or 11, further including a gate insulating film between the active layer and the gate electrode, and wherein an upper surface of the first active layer, an upper surface of the second active layer, and an upper surface of the third active layer are in contact with the gate insulating film.
Example 13: The thin film transistor of any of Examples 1 to 3 or 5 to 12, wherein a groove is formed on the upper surface of the active layer, and wherein a thickness of the active layer is smaller than a thickness of the source conductive layer and a thickness of the drain conductive layer.
Example 14: The thin film transistor of any of Examples 1 to 3 or 5 to 12, wherein a protrusion is formed on the upper surface of the active layer, and wherein a thickness of the active layer is greater than a thickness of the source conductive layer and a thickness of the drain conductive layer.
Example 15: The thin film transistor of any of Examples 1 to 14, wherein an upper surface of the active layer has a first length, wherein a lower surface of the active layer has a second length, wherein the first length is shorter than the second length, and wherein the first length and the second length are measured along a direction parallel to the first direction.
Example 16: The thin film transistor of any of Examples 1 to 15, wherein at least a portion of the source conductive layer and at least a portion of the drain conductive layer overlap the gate electrode in a plan view.
Example 17: A thin film transistor substrate comprising: a base substrate; and a first thin film transistor and a second thin film transistor disposed on the base substrate, wherein the first thin film transistor comprising: a first source conductive layer and a first drain conductive layer spaced apart from each other; a first sub-active layer disposed between the first source conductive layer and the first drain conductive layer; and a first gate electrode overlapping the first sub-active layer; and the second thin film transistor comprising: a second source conductive layer and a second drain conductive layer spaced apart from each other; a second sub-active layer disposed between the second source conductive layer and the second drain conductive layer; and a second gate electrode overlapping with the second sub-active layer, wherein a direction from the first drain conductive layer to the first source conductive layer is referred to as a first direction, and a direction perpendicular to the first direction is referred to as a second direction, wherein the first sub-active layer and the second sub-active layer are disposed to stand in a direction that is not parallel to the first direction and the second direction, wherein a maximum length of the first sub-active layer in the second direction is longer than a minimum length of the first sub-active layer in the first direction, and wherein a maximum length of the second sub-active layer in the second direction is longer than a minimum length of the second sub-active layer in the first direction.
Example 18: The thin film transistor substrate of Example 17, wherein the first source conductive layer and the second source conductive layer are formed integrally, and wherein the first thin film transistor and the second thin film transistor are connected in parallel.
Example 19: The thin film transistor substrate of Example 17 or 18, wherein the first sub-active layer has a third side surface in contact with the first source conductive layer, the second sub-active layer has a fourth side surface in contact with the second source conductive layer, and wherein the third side surface and the fourth side surface is not parallel to the first direction and the second direction, respectively.
Example 20: The thin film transistor substrate of any of Examples 17 to 19, wherein an upper surface of the first drain conductive layer, an upper surface of the first sub-active layer, an upper surface of the first source conductive layer, an upper surface of the second source conductive layer, an upper surface of the second sub-active layer, and an upper surface of the second drain conductive layer form one plane.
Example 21: A method for manufacturing a thin film transistor comprising the steps of: forming a buffer layer on a base substrate; forming a first metal material layer on the buffer layer; forming an active material layer on the first metal material layer; forming a second metal material layer on the active material layer; performing a chemical mechanical polishing process to flatten upper surfaces of the first metal material layer, the active material layer, and the second metal material layer to form a source conductive layer and a drain conductive layer spaced apart from each other and an active layer disposed between the source conductive layer and the drain conductive layer; forming a gate insulating film on the source conductive layer, the drain conductive layer, and the active layer; and forming a gate electrode on the gate insulating film, wherein a direction from the drain conductive layer to the source conductive layer is referred to as a first direction and a direction perpendicular to the first direction is referred to as a second direction, wherein the active layer is formed to stand in a direction that is not parallel to the first direction and the second direction, and wherein a maximum length of the active layer in the second direction is longer than a minimum length of the active layer in the first direction.
Example 22: The method for manufacturing the thin film transistor of Example 21, wherein the first metal material layer and the second metal material layer are made of different materials, and wherein a work function of the second metal material layer is greater than a work function of the first metal material layer.
Example 23: A display apparatus including a thin film transistor of any of Examples 1 to 16 or a thin film transistor substrate of any of Examples 17 to 20.

According to the present disclosure, the following advantageous effects may be obtained.

A thin film transistor according to one embodiment of the present invention may have a short channel by including an active layer erected at a certain angle.

A thin film transistor according to another embodiment of the present invention can have improved reliability and mobility by including a source conductive layer and a drain conductive layer having different work functions.

According to another embodiment of the present invention, a thin film transistor can improve high junction stress (HJS) by disposing a plurality of active layers having different mobilities in the horizontal direction of a substrate.

## Claims

1. A thin film transistor (100, 200, 300, 400, 500) comprising:
a source conductive layer (135) and a drain conductive layer (136) spaced apart from each other;
an active layer (130) disposed between the source conductive layer (135) and the drain conductive layer (136); and
a gate electrode (150) overlapping the active layer (130),
wherein a direction from the drain conductive layer (136) to the source conductive layer (135) is referred to as a first direction (X) and a direction perpendicular to the first direction (X) is referred to as a second direction (Y),
wherein the active layer (130) is disposed to stand in a direction that is not parallel to the first direction (X) and the second direction (Y), and
wherein a maximum length of the active layer (130) in the second direction (Y) is longer than a minimum length of the active layer (130) in the first direction (X).

2. The thin film transistor (100, 200, 300, 400, 500) of claim 1,
wherein the active layer (130) has a first side surface (SS1) in contact with the source conductive layer (135) and a second side surface (SS2) in contact with the drain conductive layer (136), and
wherein the first side surface (SS1) and the second side (SS2) surface are not parallel to the first direction (X) and the second direction (Y), and are parallel to each other.

3. The thin film transistor (100, 200, 300, 400, 500) of claim 1 or 2, wherein an entire area of the active layer (130) overlaps with the gate electrode (150).

4. The thin film transistor (100, 200, 300) of any of claims 1 to 3,
wherein an upper surface (TS1) of the active layer (130), an upper surface (TS2) of the source conductive layer (135), and an upper surface (TS3) of the drain conductive layer (136) form one plane.

5. The thin film transistor (400, 500) of any of claims 1 to 3,
wherein:
a groove (H1) is formed on the upper surface (TS1) of the active layer (130), and a thickness of the active layer (130) is smaller than a thickness of the source conductive layer (135) and a thickness of the drain conductive layer (136);
or wherein:
a protrusion (H2) is formed on the upper surface (TS1) of the active layer (130), and a thickness of the active layer (130) is greater than a thickness of the source conductive layer (135) and a thickness of the drain conductive layer (136).

6. The thin film transistor (100, 200, 300, 400, 500) of any of claims 1 to 5, further comprising a buffer layer (120), wherein the active layer (130) is disposed on the buffer layer (120), and
wherein a lower surface (BS1) of the active layer (130), a lower surface (BS2) of the source conductive layer (135), and a lower surface (BS3) of the drain conductive layer (136) are in contact with the buffer layer (120) to form one plane.

7. The thin film transistor (100, 200, 300, 400, 500) of any of claims 1 to 6, wherein the source conductive layer (135) and the drain conductive layer (136) are made of different materials,
wherein a work function of the source conductive layer (135) is smaller than a work function of the gate electrode (150), and
wherein a work function of the drain conductive layer (136) is larger than the work function of the gate electrode (150).

8. The thin film transistor (200, 300) of any of claims 1 to 7, wherein the active layer (130) includes:
a first active layer (131) in contact with the source conductive layer (135); and
a second active layer (132) in contact with the drain conductive layer (136),
wherein the second active layer (132) does not contact the source conductive layer (135), and
wherein in a part of the thickness of the active layer (130), an arbitrary straight line parallel to an upper surface (TS1) of the active layer (130) passes through the first active layer (131) and the second active layer (132),
wherein, preferably, the thin film transistor (300) further comprises:
a gate insulating film (140) between the active layer (130) and the gate electrode (150), wherein an upper surface of the first active layer (131) and an upper surface of the second active layer (132) are in contact with the gate insulating film (140).

9. The thin film transistor (200, 300) of claim 8, wherein a mobility of the second active layer (132) is greater than a mobility of the first active layer (131).

10. The thin film transistor (300) of claim 8 or 9, wherein the active layer (130) further includes a third active layer (133) between the first active layer (131) and the second active layer (132),
wherein the third active layer (133) is not in contact with the source conductive layer (135), and
wherein in a part of the thickness of the active layer (130), any straight line parallel to an upper surface (TS1) of the active layer (130) passes through the first active layer (131), the second active layer (132), and the third active layer (133),
wherein, preferably, the thin film transistor (300) further comprises:
a gate insulating film (140) between the active layer (130) and the gate electrode (150), wherein an upper surface of the first active layer (131), an upper surface of the second active layer (132), and an upper surface of the third active layer (133) are in contact with the gate insulating film (140).

11. The thin film transistor (300) of claim 10, wherein a mobility of the third active layer (133) is greater than the mobility of the first active layer (131) and less than the mobility of the second active layer (132).

12. The thin film transistor (100, 200, 300, 400, 500) of any of claims 1 to 11, wherein an upper surface (TS1) of the active layer (130) has a first length (L1),
wherein a lower surface (BS1) of the active layer (130) has a second length (L2),
wherein the first length (L1) is shorter than the second length (L2), and
wherein the first length (L1) and the second length (L2) are measured along a direction parallel to the first direction (X).

13. The thin film transistor (100) of any of claims 1 to 12, wherein at least a portion of the source conductive layer (135) and at least a portion of the drain conductive layer (136) overlap the gate electrode (150) in a plan view.

14. A thin film transistor substrate (600) comprising:
a base substrate (110); and
a first thin film transistor (T1) according to any of claims 1 to 13 and a second thin film transistor (T2) according to any of claims 1 to 13 that are disposed on the base substrate (110),
wherein, preferably:
the source conductive layer (135a) of the first thin film transistor (T1) and the source conductive layer (135b) of the second thin film transistor (T2) are formed integrally, and the first thin film transistor (T1) and the second thin film transistor (T2) are connected in parallel;
wherein, further preferably:
the active layer (130a) of the first thin film transistor (T1) has a third side surface (SS3) in contact with the source conductive layer (135a) of the first thin film transistor (T1), the active layer (130b) of the second thin film transistor (T2) has a fourth side surface (SS4) in contact with the source conductive layer (135b) of the second thin film transistor (T2), and the third side surface (SS3) and the fourth side surface (SS4) are not parallel to the first direction (X) and the second direction (Y), respectively; and
wherein, further preferably:
the third side surface (SS3) and the fourth side surface (SS4) are not parallel to each other and, preferably, have a same taper angle.

15. A display apparatus (1000) including a thin film transistor (100, 200, 300, 400, 500) of any one of claims 1 to 13 or a thin film transistor substrate (600) of claim 14.
